# EUROPEAN PATENT APPLICATION

(11) **EP 4 538 931 A1**
(43) Date of publication of application: **16.04.2025**
(21) Application number: 24206061.4
(22) Date of filing: 11.10.2024
(51) Int. Cl.: G06N 3/0455, G06N 3/08

(54) **BEHAVIOR PREDICTION USING SCENE-CENTRIC REPRESENTATIONS**

(30) Priority: 12.10.2023 US 202363589700 P
(71) Applicant: Waymo LLC, Mountain View, CA 94043 (US)
(72) Inventor: DOUILLARD, Bertrand Robert, Mountain View, CA 94043 (US); ZHOU, Aurick Qikun, Mountain View, CA 94043 (US); AL-RFOU, Rami, Mountain View, CA 94043 (US); GOEL, Kratarth, Mountain View, CA 94043 (US); SAPP, Benjamin, Mountain View, CA 94043 (US); CORNMAN, Andre Liang, Mountain View, CA 94043 (US); PARK, Cheolho, Mountain View, CA 94043 (US); LIU, Lingyun, Mountain View, CA 94043 (US)
(74) Representative: Derry, Paul Stefan

(57) **Abstract**

A method performed by one or more computers, the method comprising: obtaining scene context data characterizing a scene in an environment at a current time point, wherein the scene context data includes features of the scene in a scene-centric coordinate system; generating a scene-centric encoded representation of the scene in the environment by processing the scene context data using an encoder neural network; for each target agent: obtaining agent-specific features for the target agent, processing the agent-specific features for the target agent and the scene-centric encoded representation of the scene using a fusion neural network to generate a fused scene representation for the target agent, and processing the fused scene representation for the target agent using a decoder neural network to generate a trajectory prediction output for the target agent in an agent-centric coordinate system for the target agent.

## Description

### BACKGROUND

This specification relates to predicting the future trajectory of an agent in an environment.

The environment may be a real-world environment, and the agent may be, e.g., a vehicle, cyclist, pedestrian, or other vehicle in the environment. Predicting the future trajectories of agents is a task required for motion planning, e.g., by an autonomous vehicle.

Autonomous vehicles include self-driving cars, boats, and aircraft. Autonomous vehicles use a variety of on-board sensors and computer systems to detect nearby objects and use such detections to make control and navigation decisions.

### BRIEF DESCRIPTION OF THE DRAWINGS

FIG. 1 is a diagram of an example system.
FIG. 2 shows a trajectory prediction model.
FIG. 3 shows a detailed version of the trajectory prediction model of FIG. 2.
FIG. 4 is a flow diagram of an example process for trajectory prediction.
FIG. 5 is a flow diagram of an example process for training a trajectory prediction model.

Like reference numbers and designations in the various drawings indicate like elements.

### DETAILED DESCRIPTION

This specification describes a system implemented as computer programs on one or more computers in one or more locations that generates trajectory predictions for one or more target agents, e.g., a vehicle, a cyclist, or a pedestrian, in an environment. Each trajectory prediction is a prediction that defines the future trajectory of the corresponding target agent starting from a current time point.

Predicting the future behavior of road users is a challenging and important problem for autonomous driving and control of other types of autonomous vehicles. Moreover, when trajectory predictions need to be generated on-board the vehicle, there are strict latency requirements for generating the trajectory predictions so that they can be used to make timely control decisions for the autonomous vehicle.

One approach for generating trajectory prediction is to use an agent-centric neural network. Agent-centric neural networks process a respective agent-centric input for each agent in a scene. Each agent-centric input is computed separately and is in an agent centric coordinate system where the corresponding agent is positioned at the origin of the coordinate system.

However, using an agent-centric neural network to make predictions is computationally expensive and may make it difficult to generate high quality predictions within the latency budget. This is because, for agent-centric neural networks, the computational cost required to make a prediction for all agents in a scene can potentially scale quadratically with the number of agents and scene elements in the scene. In particular, the agent-centric networks require a respective agent-centric input for each agent in the scene.

To deal with these issues, this specification describes a trajectory prediction model that includes a scene-centric encoder neural network, a fusion neural network, and an agent-centric decoder.

The encoder neural network is described as "scene-centric" because all agents in an environment are encoded within in a single input along with information about the environment. The encoder uses a predetermined point in the scene as the origin, and encodes the environment information and agents in the environment with respect to the predetermined point to generate a scene-centric encoded representation.

The fusion neural network can process the scene-centric encoded representation of the scene along with specific features for a target agent to generate a fused scene representation for the target agent.

The agent-centric decoder can process the fused scene representation for the target agent to generate a trajectory prediction output for the target agent in an agent-centric coordinate system for the target agent.

Since the encoder is scene-centric, a single encoded representation is used for all agents rather than requiring the encoder to process separate, agent-centric inputs for all agents. The fusion neural network refines the scene-centric encoded representation using agent-specific features to generate a fused scene representation that includes context that is specific to the target agent, improving the performance of the trajectory prediction model. By using the fusion neural network, the trajectory prediction model does not need to transform a scene-centric input into an agent-centric coordinate system in order to use the agent-centric decoder. The fusion model can use the agent-specific features to refine the scene-centric encoded representation to generate an appropriate input to the agent-centric decoder.

This can allow the trained trajectory prediction model to achieve performance that matches or exceeds that of a trajectory prediction neural network with an agent-centric encoder while being much more computationally efficient and generating predictions with reduced latency. In particular, because the fusion neural network is relatively computationally efficient compared to the scene-centric encoder, the majority of the processing to generate an input to the decoder only needs to be performed once (instead of requiring separate processing for each agent), significantly improving the computational efficiency of the process while maintaining or improving on the accuracy of the predictions.

The described techniques allow an on-board trajectory prediction model to make predictions within the latency requirements of the autonomous vehicle but with accuracy that matches or exceeds that of agent-centric models that cannot be deployed on the vehicle within the latency budget by making use of the fusion neural network.

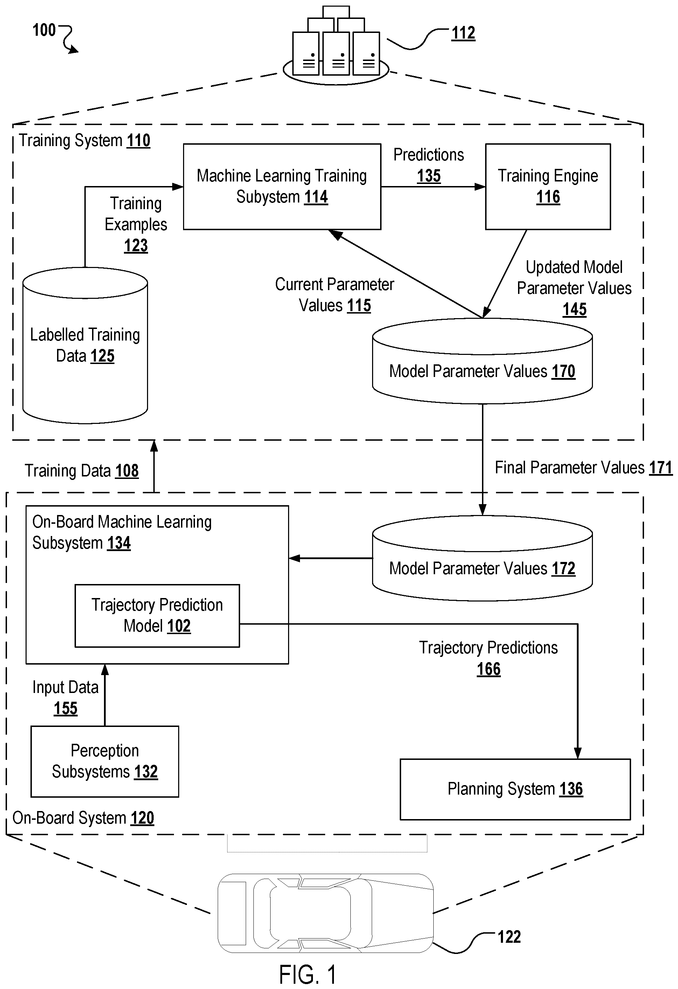

FIG. 1 is a diagram of an example system 100. The system 100 includes an on-board system 110 and a training system 120.

The on-board system 120 is located on-board a vehicle 122. The vehicle 122 in FIG. 1 is illustrated as an automobile, but the on-board system 120 can be located on-board any appropriate vehicle type.

In some cases, the vehicle 122 is an autonomous vehicle. An autonomous vehicle can be a fully autonomous vehicle that determines and executes fully-autonomous driving decisions in order to navigate through an environment. An autonomous vehicle can also be a semi-autonomous vehicle that uses predictions to aid a human driver. For example, the vehicle 122 can autonomously apply the brakes if a prediction indicates that a human driver is about to collide with another vehicle. As another example, the vehicle 122 can have an advanced driver assistance system (ADAS) that assists a human driver of the vehicle 122 in driving the vehicle 122 by detecting potentially unsafe situations and alerting the human driver or otherwise responding to the unsafe situation. As a particular example, the vehicle 122 can alert the driver of the vehicle 122 or take an autonomous driving action when an obstacle is detected, when the vehicle departs from a driving lane, or when an object is detected in a blind spot of the human driver.

The on-board system 120 includes one or more perception subsystems 132. The perception subsystems 132 can generate input data 155 characterizing a scene that includes one or more agents and the vehicle 122 in an environment. The agents can be other road users, e.g., vehicles, cyclists, pedestrians, and so on that are within the range of one or more of the sensors of the vehicle 122.

The data characterizing the scene can include data characterizing the objects in the scene, agent state history, and vehicle state history.

The data characterizing the objects in the scene can include, for any given object, one or more of the object type, object attributes (e.g., child, special vehicle, and turn signal), object property (e.g., human activity, sign), object trajectory, object coordinates, object speed, object heading, object curvature, and so on of the given object.

The agent state history can include, for all surrounding agents in the environment, a current state at the current time point and a previous state at one or more respective previous time points. In other words, the agent state history can include, for all surrounding agents in the environment, data that characterizes a previous trajectory of the agent in the environment up to the current time point. The state of an agent at a time point can include the location of the agent at the time point and, optionally, values for a predetermined set of motion parameters at the time point. As a particular example, the motion parameters can include a heading for the agent, a velocity of the agent, and/or an acceleration of the agent.

The vehicle state history can also include data characterizing a current state of the vehicle 122 at the current time point and a previous state of the vehicle 122 at one or more respective previous time points.

For example, the perception subsystems 132 can include a combination of sensor components that receive reflections of electromagnetic radiation, e.g., lidar systems that detect reflections of laser light, radar systems that detect reflections of radio waves, and camera systems that detect reflections of visible light and can use measurements from those sensors to generate data characterizing the scene.

Additionally, the perception subsystems 132 can obtain predetermined environment information, e.g., information identifying lanes, traffic signs, crosswalks, and other roadway features that can be found in a road graph or map of the environment. In some implementations, the on-board system 120 can obtain navigation history information (e.g., trajectories and speeds, headings, etc.) of the vehicle 122, e.g., from driving logs of the vehicle, and can provide the navigation history information as part of the input data 155.

Using the predetermined environment information and sensor captured information, the perception subsystems 132 can generate the input data 155 characterizing the scene.

For example, the perception subsystems 132 can use an image or a video of the agent over a period of time captured by a camera sensor, point cloud data of the agent captured by a lidar sensor, road information (e.g., lanes and stop signs), locations of surrounding objects (e.g., other vehicles and pedestrians), and so on to generate data characterizing the scene 155 that includes an agent in the environment.

The perception systems 132 provide the input data 155 to an on-board machine learning subsystem 134.

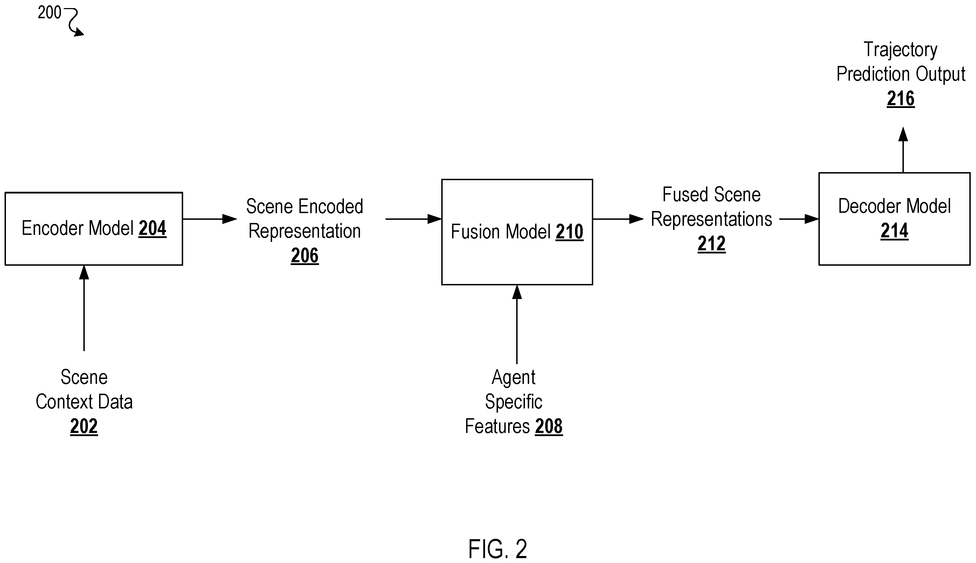

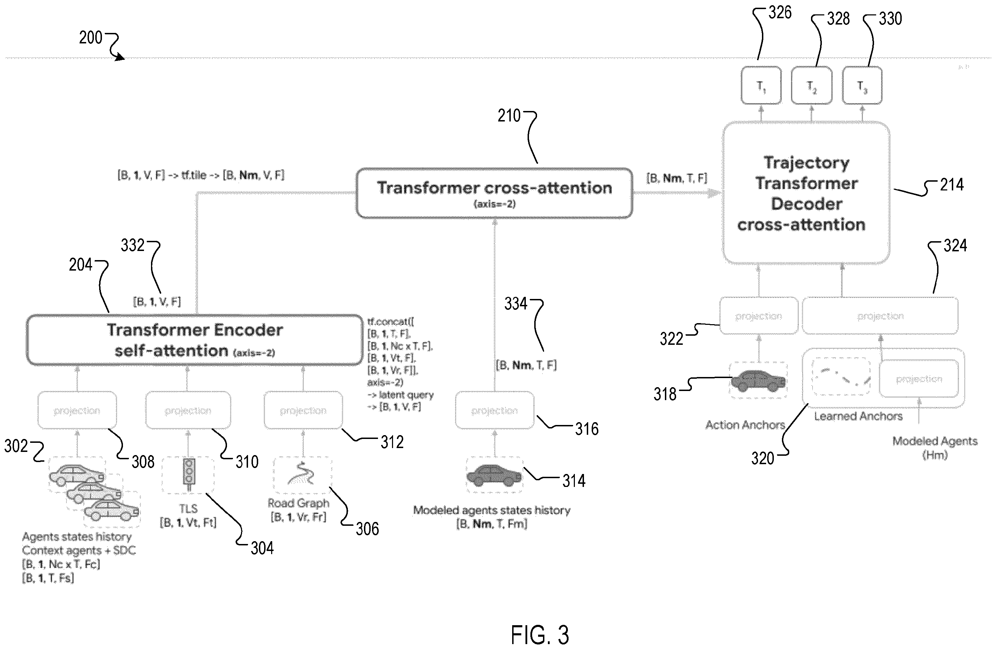

The on-board machine learning subsystem 134 implements operations of a trajectory prediction model 102. The trajectory prediction model 102 can include an encoder model, a fusion model, and a decoder model. The trajectory prediction model 102 will be described in more detail below with reference to FIGS. 2 and 3.

The trajectory prediction model 102 can process the input data 155 to generate a respective trajectory prediction output 166 for each of one or more of the surrounding agents. The trajectory prediction output 166 for a given agent characterizes the future trajectory of the agent after the current time point.

More specifically, the trajectory prediction output 166 for a given agent represents a likelihood distribution over possible future trajectories that can be followed by the agent, e.g., a probability distribution or another distribution that specifies a respective likelihood score for each of a set of possible future trajectories.

Each possible future trajectory includes data specifying a sequence of multiple waypoint spatial locations in the environment that each correspond to a possible position of the agent at a respective future time point that is after the future time point.

As a particular example, the trajectory prediction output 166 can include data defining a plurality of possible future trajectories and a respective likelihood score for each of the plurality of possible future trajectories that represents the likelihood that the possible future trajectory will be closest to the actual trajectory followed by the surrounding agent.

The data defining the future trajectories can be, for each future trajectory, a respective waypoint location at each of a fixed set of future time points that represents the location of the agent at the corresponding time point.

Alternatively, the data defining the future trajectory can be parameters of a probability distribution around the first possible future trajectory. That is, the data can be parameters of a respective parametric probability distribution for each waypoint spatial location in the possible future trajectory, i.e., a respective distribution over spatial locations for each time point in the trajectory. As a particular example, the parametric probability distribution for a given waypoint spatial location can be a Normal probability distribution over spatial locations and the data defining the parameters of the Normal probability distribution can include (i) a mean of the Normal probability distribution, and (ii) covariance parameters of the Normal probability distribution.

The on-board system 120 also includes a planning subsystem 136. The planning subsystem 136 can make autonomous or semi-autonomous driving decisions for the vehicle 122, e.g., by generating a planned vehicle path that characterizes a path that the vehicle 122 will take in the future.

The on-board system 120 can provide the trajectory prediction outputs 166 generated by the trajectory prediction model 102 to one or more other on-board systems of the vehicle 122, e.g., the planning subsystem 136.

When the planning subsystem 136 receives the trajectory prediction outputs 166, the planning system 136 can use the trajectory prediction outputs 166 to generate planning decisions that plan a future trajectory of the vehicle, i.e., to generate a new planned vehicle path. For example, the trajectory prediction outputs 166 may contain a prediction that a particular surrounding agent is likely to cut in front of the vehicle 122 at a particular future time point, potentially causing a collision. In this example, the planning system 136 can generate a new planned vehicle path that avoids the potential collision and cause the vehicle 122 to follow the new planned path, e.g., by autonomously controlling the steering of the vehicle, and avoid the potential collision.

The on-board machine learning subsystem 134 can also use the input data 155 to generate training data 108. The training data 108 can be used to train the trajectory prediction model 102. The on-board system 120 can provide the training data 108 to the training system 110 in offline batches or in an online fashion, e.g., continually whenever it is generated.

The training system 110 is typically hosted within a data center 112, which can be a distributed computing system having hundreds or thousands of computers in one or more locations.

The training system 110 includes a machine learning training subsystem 114 that can implement the operations of a trajectory prediction model 102 that is configured to generate a trajectory prediction for each of one or more agents in a scene. The machine learning training subsystem 114 includes a plurality of computing devices having software or hardware modules that implement the respective operations of a machine learning model, e.g., respective operations of each layer of a neural network according to an architecture of the neural network.

The training trajectory prediction model generally has the same architecture and parameters as the onboard trajectory prediction model 102. However, the training system 110 need not use the same hardware to compute the operations of the trajectory prediction model 102. In other words, the training system 110 can use CPUs only, highly parallelized hardware, or some combination of these.

The machine learning training subsystem 114 can compute the operations of the trajectory prediction model, e.g., the operations of each layer of a neural network, using current parameter values 115 stored in a collection of model parameter values 170. Although illustrated as being logically separated, the model parameter values 170 and the software or hardware modules performing the operations may actually be located on the same computing device or on the same memory device.

The machine learning training subsystem 114 can receive training examples 123 as input. The training examples 123 can be labeled training data 125 that is stored in a database. Each training example includes an input that characterizes a scene that includes one or more agents and a vehicle in an environment as well as one or more labels that indicate ground truth trajectories of the agents.

The machine learning training subsystem 114 can generate, for each training example 123, error predictions 135. Each error prediction 135 represents an estimate of an error between a ground truth trajectory for one or more of the plurality of agents in the scene and a trajectory for the one or more of the plurality of agents generated by the trajectory prediction model 102 that is being trained. A training engine 116 analyzes the error predictions 135 and compares the error predictions to the labels in the training examples 123 using a loss function, e.g., a classification loss or a regression loss function. The training engine 116 then generates updated model parameter values 145 by using an appropriate updating technique, e.g., stochastic gradient descent with backpropagation. The training engine 116 can then update the collection of model parameter values 170 using the updated model parameter values 145.

After training is complete, the training system 110 can provide a final set of model parameter values 171 to the on-board system 120 for use in making fully autonomous or semiautonomous driving decisions. For example, the training system 110 can provide a final set of model parameter values 171 to the trajectory prediction model 102 that runs in the on-board system 120 to generate trajectory predictions 166 for one or more of a plurality of agents in a scene. The training system 110 can provide the final set of model parameter values 171 by a wired or wireless connection to the on-board system 120.

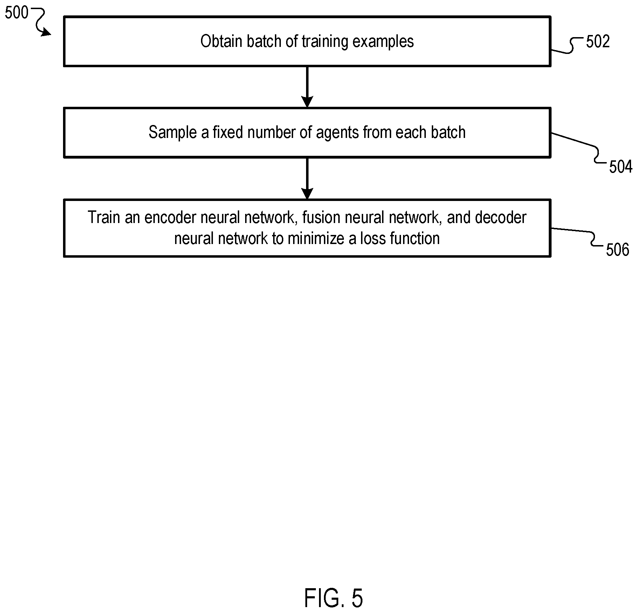

Training the trajectory prediction model 102 is described in more detail below with reference to FIG. 5.

FIG. 2 shows an example trajectory prediction model 200.

As shown in FIG. 2, the trajectory prediction model 200 includes an encoder model 204, a fusion model 210, and a decoder model 214.

The encoder model 204 is described as "scene-centric" because all agents in an environment are encoded within in a single input along with information about the environment. The encoder model 204 uses a shared point in the scene as the origin and encodes the environment information and agents in the environment with respect to the predetermined point to generate a scene-centric encoded representation 206. For example, the shared point can be the autonomous vehicle's location at the current time.

The fusion model 210 can process the scene-centric encoded representation 206 of the scene along with specific features for a target agent to generate a fused scene representation for the target agent.

The agent-centric decoder 214 can process the fused scene representation for the target agent to generate a trajectory prediction output for the target agent in an agent-centric coordinate system for the target agent.

Since the encoder model 204 is scene-centric, a single encoded representation is used for all agents rather than requiring the encoder model to process separate, agent-centric inputs for all agents.

The fusion model 210 refines the scene-centric encoded representation 206 using agent-specific features 208 to generate a fused scene representation 212 that includes context that is specific to the target agent, improving the performance of the trajectory prediction model 200.

This can allow the trajectory prediction model 200 to achieve performance that matches or exceeds that of a trajectory prediction neural network with an agent-centric encoder while being much more computationally efficient and generating predictions with reduced latency.

Optionally, the fusion model 210 and decoder model 214 can batch their processing and generate trajectory predictions for all agents in parallel.

In more detail, the encoder model 204 receives scene context data 202 and generates a scene-centric encoded representation 206 of a scene.

The fusion model 210 receives the scene-centric encoded representation 206 of the scene and respective agent-specific features 208 for each of a plurality of target agents and generates a respective fused scene representation 212 for each of the target agents from the scene-centric encoded representation 206 and the respective agent-specific features 208 for the target agent.

The decoder model 214 receives, for each target agent, the fused scene representations 212 for the target agent and generates a trajectory prediction output 216 for the target agent from the fused scene representation 212 for the target agent.

The scene context data 202 characterizes a scene in an environment at a current time step in a scene-centric coordinate system. A scene-centric coordinate system is a coordinate system that is centered at a fixed point in the scene e.g., at the location of the autonomous vehicle at the current time point. All features for all agents at all time points are in the shared scene-centric coordinate system The scene can include a plurality of agents e.g., vehicles, cyclists, pedestrians, etc. in an environment.

The scene context data 202 can include data characterizing the objects in the scene, context information about the environment, navigation history information of one or more agents in the scene, and target agent history context data.

Data characterizing the objects in the scene can include for any given object, one or more of the object type, object attributes (e.g., child, special vehicle, and turn signal), object coordinates, object speed, object heading, object curvature, and so on of the given object.

Context information of the environment can include information identifying lanes, traffic signs, crosswalks, and other roadway features that can be found in a road graph or map of the environment. The context information can include sensor data characterizing the scene. For example, the scene context data 202 can include data generated from data captured by one or more sensors of an autonomous vehicle and the target agents can be agents in a vicinity of the autonomous vehicle.

The navigation history can include a sequence of the position, velocity, orientation of the autonomous vehicle in the environment at a predetermined interval over a period of time, e.g., every 0.1 seconds in the last two seconds.

Target agent history context data characterizing current and previous states of the plurality of target agents can include, for all target agents in the environment, a current state at the current time point and a previous state at one or more respective previous time points. In other words, the target agent history context data can include, for the target agents in the environment, data that characterizes a previous trajectory of the agent in the environment up to the current time point. The state of an agent at a time point can include the location of the agent at the time point and, optionally, values for a predetermined set of motion parameters at the time point. As a particular example, the motion parameters can include a heading for the agent, a velocity of the agent, and/or an acceleration of the agent.

The encoder model 204 can be any appropriate type of machine learning model, e.g., a neural network model, or another type of machine learning model. For example, the encoder model 204 can be a self-attention encoder that can encode one or more modalities across temporal and spatial dimensions. Driving scenes can consist of multimodal data, such as road information, traffic light state, agent history, and agent interactions. Some modalities can have both spatial dimensions (i.e., data at different locations within the scene) and temporal dimensions (i.e.., data at different timepoints). The encoder model 204 can include one or more attention encoders that summarize the driving scene. The one or more attention encoders can include multi-axis attention encoders and/or factorized attention encoders. The encoder model 204 can include both spatial encoder blocks and temporal encoder blocks that can encode data with different modalities.

The encoder model 204 can be used to generate a scene-centric encoded representation 206 of the scene characterized by the scene context data 202. The scene-centric encoded representation 206 of the scene represents the scene context data 202 in a scene-centric coordinate system that is, e.g., centered at a pre-determined point in the scene.

In some implementations, the scene-centric encoded representation 206 of the scene includes a sequence of scene embeddings. Each scene embedding in the sequence of embeddings can be an ordered collection of numerical values, e.g., a vector, matrix, or other tensor of numerical values.

The fusion model 210 can be any appropriate type of machine learning model, e.g., a neural network model or another type of machine learning model. For example, the fusion model can be a late fusion encoder model with one or more cross-attention layers. The late fusion encoder model dedicates an attention encoder for each modality.

The fusion model 210 processes the scene-centric encoded representation 206 of the scene and agent-specific features 208 for each target agent in the scene to generate a fused scene representation 212 for the target agent. The fusion model 210 can generate the fused scene representations 212 for all target agents in the scene. The fused scene representation 212 for a given agent is latent information that is not explicitly in a specific coordinate system but that provides context information that is specific to the given agent and that can be used to make accurate trajectory predictions for the target agent. For example, the fused scene representation 212 can include a sequence of vectors that provide context information that is specific to the given agent.

The agent-specific features 208 for a given target agent can include agent history context data characterizing current and previous states of the target agent in the scene-centric coordinate system. The agent history data for the given target agent can include a current state at the current time point and a previous state at one or more respective previous time points. The state of the target agent at a time point can include the location of the target agent at the time point and, optionally, values for a predetermined set of motion parameters at the time point. As a particular example, the motion parameters can include a heading for the target agent, a velocity of the target agent, and/or an acceleration of the target agent.

In some implementations, the agent specific features include features for the target agent from the scene context data 202 as well as additional features for the target agent. For example, the scene context data 202 can include target agent history data characterizing current and previous states of the target agents and the agent-specific features 208 can include the target agent history data from the scene context data along with agent-specific features for each target agent.

In some implementations, the agent-specific features 208 for a given target agent include a combination of features in the scene-centric coordinate system and features in an agent-centric coordinate system. An agent-centric coordinate system for a target agent is a coordinate system centered around the target agent.

The features in an agent-specific coordinate system for a given target agent can include any appropriate features represented in the agent-centric coordinate system.

For example, the features can include the state history of the target agent represented in the agent-centric coordinate system for the target agent, current states or state histories of one or more other agents represented in the agent-centric coordinate system for the target agent, or both.

As another example, the features can also include features that represent roadgraph information, e.g., road information or other landmarks in the agent-centric coordinate system.

As another example, the features can include one or more "anchor" future trajectories of the given agent represented in the agent-centric coordinate system. The anchor future trajectories are example future trajectories that can be traversed by the given agent. For example, these anchor future trajectories can be pre-determined based on the type of the given agent, or can be predicted by another, more computationally-efficient prediction model. In some cases, the system can only include the anchor trajectories for certain agent types while not including the anchors for other agent types.

In some implementations, the fusion model 210 can generate a sequence of agent embeddings from the agent-specific features.

The fusion model 210 can then process the sequence of agent embeddings and the encoded representation to generate the fused scene representation. For example, the scene-centric encoded representation of the scene can be a sequence of scene embeddings and the fusion neural network can have at least one cross-attention neural network block that performs cross attention between the sequence of scene embeddings and the sequence of agent embeddings.

The decoder model 214 can be any appropriate type of machine learning model, e.g., a neural network model, or another type of machine learning model. For example, the decoder model 214 can be a neural network that includes a stack of one or more standard transformer cross-attention blocks.

The decoder model 214 can be used to generate a trajectory prediction output 216 for each target agent in the scene from the fused scene representation for the target agent.

The trajectory prediction output 216 for a given target agent represents a likelihood distribution over possible future trajectories that can be followed by the agent, e.g., a probability distribution or another distribution that specifies a respective likelihood score for each of a set of possible future trajectories. The trajectory prediction output 216 for a given target agent is in the agent-centric coordinate system centered at the position of the target agent at the current time.

Each possible future trajectory includes data specifying a sequence of multiple waypoint spatial locations in the environment that each correspond to a possible position of the target agent at a respective future time point that is after the future time point.

As a particular example, the trajectory prediction output 216 can include data defining a plurality of possible future trajectories and a respective likelihood score for each of the plurality of possible future trajectories that represents the likelihood that the possible future trajectory will be closest to the actual trajectory followed by the target agent.

The data defining the future trajectories can be, for each future trajectory, a respective waypoint location at each of a fixed set of future time points that represents the location of the target agent at the corresponding time point.

Alternatively, the data defining the future trajectory can be parameters of a probability distribution around the first possible future trajectory. That is, the data can be parameters of a respective parametric probability distribution for each waypoint spatial location in the possible future trajectory, i.e., a respective distribution over spatial locations for each time point in the trajectory. As a particular example, the parametric probability distribution for a given waypoint spatial location can be a Normal probability distribution over spatial locations and the data defining the parameters of the Normal probability distribution can include (i) a mean of the Normal probability distribution, and (ii) covariance parameters of the Normal probability distribution.

FIG. 3 shows a detailed example of the trajectory prediction model 200 of FIG. 2.

More specifically, FIG. 3 shows an example of the trajectory prediction model 200 in an example where predictions are made for three future time steps *T*₁, *T*₂*,* and *T*₃.

In the example of FIG. 3, B refers to a batch size that specifies the number of scenes for which a prediction is made in parallel, *T* refers to the number of time steps for which scene context data is available, *Nc* refers to the number of context agents in a given scene, i.e., the number of context agents characterized by the scene context data, and *Nm* refers to the number of "modeled" agents, i.e., the number of target agents for which predictions are being made

The encoder model 204 receives scene context data characterizing a scene in a scene-centric coordinate system. The encoder model 204 can receive road graph information 306, traffic light information 304, motion history (i.e., agents states history) 302 as a part of the scene context data. The encoder model 204 can use a respective linear projection 308, 310, and 312 for each type of data 302, 304, and 306 to map the data to a shared dimensionality.

For the road graph information 306, a road graph encoder can use polylines to encode the road elements from a 3D high definition map with an MLP to generate Vr features, i.e., one for each polyline, of size Fr.

For traffic light information 304, a traffic signal encoder can use a recurrent neural network, e.g., an LSTM, to encode the traffic light information to generate Vt features, i.e., one feature for each traffic light, of size Ft.

For the motion history and agent interactions 302, a motion encoder can use a transformer neural network to encode a sequence of past observations per each agent. For example, the system can generate a respective feature of size Fc for each context agent at each time step and a feature for the autonomous vehicle at each time step of size Fs.

The encoder model 204 can process a combined sequence of embeddings of each type of scene context data through a plurality of self-attention blocks to generate a scene-centric encoded representation 332 for the scene in the scene-centric coordinate frame that includes a sequence of scene embeddings, i.e., a sequence of V scene embeddings of size F.

For each of the target agents, the fusion model 210 can process the scene-centric encoded representation 332 along with agent-specific state history 314 for the target agent in a scene centric coordinate system. The one or more target agents are a proper subset of the total agents 302 in the scene for which predictions are to be made. The fusion model can include an agent history encoder 316 to encode the agent-specific state history 314 for the target agents in a sequence of agent embeddings 334.

In some examples, the fusion model 210 can have at least one cross-attention neural network block that performs cross attention between the sequence of scene embeddings 332 and the sequence of agent embeddings 334 to generate a fused representation for each of the target agents. The sequence of scene embeddings 332 are used to generate the key/values and the sequence of agent embeddings 334 are used to generate the queries for the cross-attention. In some examples, the fusion model 210 can receive road graph information in an agent-centric coordinate system for each target agent. The fusion model 210 can include an additional encoder that encodes the agent-centric road graph information.

For example, the fusion model 210 can include only one or more cross-attention blocks or can include one or more self-attention blocks that apply self-attention over the sequence of agent embeddings 334 in addition to the cross-attention block(s). Generally, however, the fusion model 210 is significantly more computationally efficient than the encoder 204. More specifically, significantly fewer computational resources are required to encode the agent-specific features 314 and perform the operations of the fusion model 210 than are required to encode the scene context data and perform the operations of the encoder 204. Thus, only needing to encode the agent-specific features 314 and perform the operations of the fusion model 210 once per scene is significantly more computationally efficient than separately encoding the scene context data for each target agent, i.e., represented in the agent-centric coordinate system of the agent.

The decoder model 214 can then process the fused representations for the target agents using a decoder to generate the trajectory predictions 326, 328, and 330. The decoder can be, e.g., a multi-layer perceptron (MLP), a Transformer, or a recurrent neural network (RNN). For example, the decoder can include a stack of one or more transformer cross-attention blocks, in which initial queries are fed in, and then cross-attended with the scene embedding 332 to produce trajectories. The decoder can also include one or more self-attention blocks that self-attend over the initial queries. Generally, the initial queries include a set of learned queries 320 that learned during the training of the decoder model 214. In some implementations, the initial queries also include a set of "anchor" queries 318 that are not learned, but that represent pre-determined or predictor "anchor" future trajectories as described above. As described above, in some cases, the system uses the anchor trajectories only for agents of certain types.

The decoder model 214 can use a respective linear projection 322 and 324 for each initial query 318 and 320 to map the learned initial queries to a shared dimensionality.

The decoder model 214 can output a mixture of Gaussians to represent the possible trajectories an agent may take. For example, the decoder model 214 can process the updated queries using an output neural network head to generate the parameters of the mixture of Gaussians for a given agent. For example, the system can output, for each future time step and for each mode of the mixture, a probability for the mode, the mean of the mode at the future time step and, optionally, parameters that define the variance from the mode at the future time step.

In order to generate respective trajectory prediction outputs 326, 328, and 330 for each of the target agents using the decoder model 214, the fusion model 210 needs to generate a fused scene representation for the target agents. The system then processes the fused scene representation to generate a respective trajectory prediction output 326, 328, and 330 for each of the target agents.

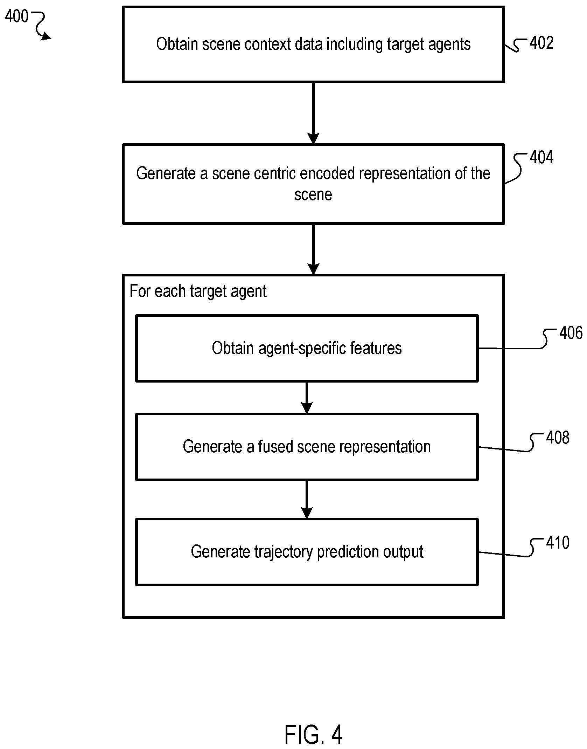

FIG. 4 is a flow diagram of an example process 400 for trajectory prediction. For convenience, the process 400 will be described as being performed by a system of one or more computers located in one or more locations. For example, a trajectory prediction model, e.g., the on-board system 120 of FIG. 1 appropriately programmed in accordance with this specification, can perform the process 400.

The system obtains scene context data characterizing a scene in an environment and a set of target agents in the environment (Step 402). The scene context data characterizes a scene in an environment at a current time step in a scene-centric coordinate system. The target agents can be other road users, e.g., vehicles, cyclists, pedestrians, etc.

The scene context data can include context information of the environment (e.g., information identifying lanes, traffic signs, crosswalks, and other roadway features that can be found in a road graph or map of the environment). The context information can include sensor data characterizing the scene. For example, the scene context data can include data generated from data captured by one or more sensors of an autonomous vehicle and the target agents can be agents in a vicinity of the autonomous vehicle.

The scene context data can include target agent history context data characterizing current and previous states of the set of target agents. For example, the scene context data 202 can include, for all target agents in the environment, a current state at the current time point and a previous state at one or more respective previous time points.

The system processes the scene context data to generate a scene-centric encoded representation of the scene characterized by the scene context data using an encoder model (step 404).

In some implementations, the scene-centric encoded representation of the scene includes a sequence of scene embeddings. The sequence of embeddings can be an ordered collection of numerical values, e.g., a vector, matrix, or other tensor of numerical values.

For each target agent in the set of target agents, the system obtains agent specific features for the target agent (step 406). The agent-specific features for a given target agent can include agent history context data characterizing current and previous states of the target agent in the scene-centric coordinate system. The agent history data for the given target agent can include a current state at the current time point and a previous state at one or more respective previous time points. The state of the target agent at a time point can include the location of the target agent at the time point and, optionally, values for a predetermined set of motion parameters at the time point. As a particular example, the motion parameters can include a heading for the target agent, a velocity of the target agent, and/or an acceleration of the target agent.

In some implementations, the agent specific features include features for the target agent from the scene context data 202 as well as additional features for the target agent. For example, the scene context data 202 can include target agent history data characterizing current and previous states of the target agents and the agent-specific features 208 can include the target agent history data from the scene context data along with agent-specific features for each target agent.

In some implementations, the agent-specific features for a given target agent include a combination of features in the scene-centric coordinate system and features in an agent-centric coordinate system. The features in an agent-specific coordinate system can include state history of each of the target agents.

The system processes the agent-specific features for the target agent and the scene-centric encoded representation of the scene using a fusion model to generate a fused scene representation for the target agent (step 408).

The system processes the fused scene representation for the target agent to generate a trajectory prediction output for the target agent (step 410). The trajectory prediction output for a given target agent can include a future trajectory of the target agent after the current time point in an agent-centric coordinate system for the target agent. The trajectory prediction output can define a probability distribution over possible future trajectories of the target agent after the current time point. For example, the trajectory prediction output can include a respective likelihood score for each of multiple future trajectories and, optionally, data defining each of the multiple future trajectories. For example, the multiple future trajectories can be the modes of a mixture of Gaussians as described above.

FIG. 5 is a flow diagram of an example process 500 for training a trajectory prediction system. For convenience, the process 500 will be described as being performed by a system of one or more computers located in one or more locations. For example, a training system, e.g., the training system 110 of FIG. 1, appropriately programmed in accordance with this specification, can perform the process 500.

At a high level, to perform the process 500, the system obtains a mini-batch of training examples and updates the current values of the model parameters using the mini-batch.

By repeatedly updating the model parameter values in this manner for different mini-batches of training examples, the system can train the trajectory prediction neural network to generate accurate trajectory prediction outputs.

The system obtains a batch of training examples (Step 502). Each training example includes scene data characterizing a scene that can include one or more agents at a first time point. The training example also includes a ground truth agent trajectory for all or some of the of the one or more agents in the scene that identifies the actual trajectory followed by the agent after the first time point.

The system samples a fixed number of agents from the batch (Step 504). For example, a batch may have 500 training examples where a portion of training examples have few agents in the corresponding scene, i.e., correspond to a sparse scene that is sparsely populated with agents, and other training examples have many agents, i.e., correspond to a crowded scene that is densely populated with agents. Instead of training on many examples with few agents, the system samples a fixed number of agents across all scenes in a batch of training examples.

In some examples, the system can select a fixed number of agents from a scene in the batch either at random or according a priority score for each agent. The fixed number of agents can be a number of agents that most scenes in the batch are likely to contain.

In some examples, the system can select the number of agents sampled from a particular training example based on how crowded the scene characterized by its scene data is. The number of agents sampled from a scene can be higher for densely populated scenes (i.e., 15) and lower for sparsely populated scenes (i.e., 2).

In some examples, the system can categorize agents as either vehicle agents or non-vehicle agents. The system can choose a fixed number of vehicle agents to sample and a fixed number of non-vehicle agents to sample.

The system jointly trains an encoder neural network, a fusion neural network, and decoder neural network to minimize a loss function (Step 506) using the ground truth trajectories for the agents sampled from the batch of training examples.

For example, the system can determine a gradient with respect to the model parameters of the loss function. The system can compute the gradient, e.g., through backpropagation. The system can then update the model parameters using the gradients, e.g., by applying an optimizer to the gradient with respect to the model parameters.

The loss function can include one or more terms that measure, for each training example and for each of the respective plurality of agents in the respective scene characterized by the training example, a difference between (i) the ground truth trajectory for the agent and (ii) the trajectory closest to the ground truth trajectory in the trajectory prediction output generated for the agent by the decoder neural network.

For example, when the trajectory prediction is a mixture of Gaussians the loss can have a classification loss term that measures the log probability assigned by the trajectory closest to the ground truth trajectory in the trajectory prediction output and a regression loss term that measures the log probability assigned to the ground truth trajectory by the probability distribution that defines the closest trajectory in the trajectory prediction output.

Although the description above describes the trajectory predictions being made on-board a vehicle after training, as another example, the trajectory predictions may be made in a computer simulation of a real-world environment being navigated through by a simulated autonomous vehicle and the target agents. Generating these predictions in simulation may assist in controlling the simulated vehicle and in testing the realism of certain situations encountered in the simulation. More generally, generating these predictions in simulation can be part of testing the control software of a real-world autonomous vehicle before the software is deployed on-board the autonomous vehicle, of training one or more machine learning models that will later be deployed on-board the autonomous vehicle or both.

Embodiments of the subject matter and the functional operations described in this specification can be implemented in digital electronic circuitry, in tangibly-embodied computer software or firmware, in computer hardware, including the structures disclosed in this specification and their structural equivalents, or in combinations of one or more of them. Embodiments of the subject matter described in this specification can be implemented as one or more computer programs, i.e., one or more modules of computer program instructions encoded on a tangible non-transitory storage medium for execution by, or to control the operation of, data processing apparatus. The computer storage medium can be a machine-readable storage device, a machine-readable storage substrate, a random or serial access memory device, or a combination of one or more of them. Alternatively or in addition, the program instructions can be encoded on an artificially-generated propagated signal, e.g., a machine-generated electrical, optical, or electromagnetic signal, that is generated to encode information for transmission to suitable receiver apparatus for execution by a data processing apparatus.

The term "data processing apparatus" refers to data processing hardware and encompasses all kinds of apparatus, devices, and machines for processing data, including by way of example a programmable processor, a computer, or multiple processors or computers. The apparatus can also be, or further include, off-the-shelf or custom-made parallel processing subsystems, e.g., a GPU or another kind of special-purpose processing subsystem. The apparatus can also be, or further include, special purpose logic circuitry, e.g., an FPGA (field programmable gate array) or an ASIC (application-specific integrated circuit). The apparatus can optionally include, in addition to hardware, code that creates an execution environment for computer programs, e.g., code that constitutes processor firmware, a protocol stack, a database management system, an operating system, or a combination of one or more of them.

A computer program which may also be referred to or described as a program, software, a software application, an app, a module, a software module, a script, or code) can be written in any form of programming language, including compiled or interpreted languages, or declarative or procedural languages, and it can be deployed in any form, including as a stand-alone program or as a module, component, subroutine, or other unit suitable for use in a computing environment. A program may, but need not, correspond to a file in a file system. A program can be stored in a portion of a file that holds other programs or data, e.g., one or more scripts stored in a markup language document, in a single file dedicated to the program in question, or in multiple coordinated files, e.g., files that store one or more modules, sub-programs, or portions of code. A computer program can be deployed to be executed on one computer or on multiple computers that are located at one site or distributed across multiple sites and interconnected by a data communication network.

For a system of one or more computers to be configured to perform particular operations or actions means that the system has installed on it software, firmware, hardware, or a combination of them that in operation cause the system to perform the operations or actions. For one or more computer programs to be configured to perform particular operations or actions means that the one or more programs include instructions that, when executed by data processing apparatus, cause the apparatus to perform the operations or actions.

As used in this specification, an "engine," or "software engine," refers to a software implemented input/output system that provides an output that is different from the input. An engine can be an encoded block of functionality, such as a library, a platform, a software development kit ("SDK"), or an object. Each engine can be implemented on any appropriate type of computing device, e.g., servers, mobile phones, tablet computers, notebook computers, music players, e-book readers, laptop or desktop computers, PDAs, smart phones, or other stationary or portable devices, that includes one or more processors and computer readable media. Additionally, two or more of the engines may be implemented on the same computing device, or on different computing devices.

The processes and logic flows described in this specification can be performed by one or more programmable computers executing one or more computer programs to perform functions by operating on input data and generating output. The processes and logic flows can also be performed by special purpose logic circuitry, e.g., an FPGA or an ASIC, or by a combination of special purpose logic circuitry and one or more programmed computers.

Computers suitable for the execution of a computer program can be based on general or special purpose microprocessors or both, or any other kind of central processing unit. Generally, a central processing unit will receive instructions and data from a read-only memory or a random access memory or both. The essential elements of a computer are a central processing unit for performing or executing instructions and one or more memory devices for storing instructions and data. The central processing unit and the memory can be supplemented by, or incorporated in, special purpose logic circuitry. Generally, a computer will also include, or be operatively coupled to receive data from or transfer data to, or both, one or more mass storage devices for storing data, e.g., magnetic, magneto-optical disks, or optical disks. However, a computer need not have such devices. Moreover, a computer can be embedded in another device, e.g., a mobile telephone, a personal digital assistant (PDA), a mobile audio or video player, a game console, a Global Positioning System (GPS) receiver, or a portable storage device, e.g., a universal serial bus (USB) flash drive, to name just a few.

Computer-readable media suitable for storing computer program instructions and data include all forms of non-volatile memory, media and memory devices, including by way of example semiconductor memory devices, e.g., EPROM, EEPROM, and flash memory devices; magnetic disks, e.g., internal hard disks or removable disks; magneto-optical disks; and CD-ROM and DVD-ROM disks.

To provide for interaction with a user, embodiments of the subject matter described in this specification can be implemented on a computer having a display device, e.g., a CRT (cathode ray tube) or LCD (liquid crystal display) monitor, for displaying information to the user and a keyboard and pointing device, e.g., a mouse, trackball, or a presence sensitive display or other surface by which the user can provide input to the computer. Other kinds of devices can be used to provide for interaction with a user as well; for example, feedback provided to the user can be any form of sensory feedback, e.g., visual feedback, auditory feedback, or tactile feedback; and input from the user can be received in any form, including acoustic, speech, or tactile input. In addition, a computer can interact with a user by sending documents to and receiving documents from a device that is used by the user; for example, by sending web pages to a web browser on a user's device in response to requests received from the web browser. Also, a computer can interact with a user by sending text messages or other forms of message to a personal device, e.g., a smartphone, running a messaging application, and receiving responsive messages from the user in return.

Embodiments of the subject matter described in this specification can be implemented in a computing system that includes a back-end component, e.g., as a data server, or that includes a middleware component, e.g., an application server, or that includes a front-end component, e.g., a client computer having a graphical user interface, a web browser, or an app through which a user can interact with an implementation of the subject matter described in this specification, or any combination of one or more such back-end, middleware, or front-end components. The components of the system can be interconnected by any form or medium of digital data communication, e.g., a communication network. Examples of communication networks include a local area network (LAN) and a wide area network (WAN), e.g., the Internet.

The computing system can include clients and servers. A client and server are generally remote from each other and typically interact through a communication network. The relationship of client and server arises by virtue of computer programs running on the respective computers and having a client-server relationship to each other. In some embodiments, a server transmits data, e.g., an HTML page, to a user device, e.g., for purposes of displaying data to and receiving user input from a user interacting with the device, which acts as a client. Data generated at the user device, e.g., a result of the user interaction, can be received at the server from the device.

While this specification contains many specific implementation details, these should not be construed as limitations on the scope of any invention or on the scope of what may be claimed, but rather as descriptions of features that may be specific to particular embodiments of particular inventions. Certain features that are described in this specification in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially be claimed as such, one or more features from a claimed combination can in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system modules and components in the embodiments described above should not be understood as requiring such separation in all embodiments, and it should be understood that the described program components and systems can generally be integrated together in a single software product or packaged into multiple software products.

Particular embodiments of the subject matter have been described. Other embodiments are within the scope of the following claims. For example, the actions recited in the claims can be performed in a different order and still achieve desirable results. As one example, the processes depicted in the accompanying figures do not necessarily require the particular order shown, or sequential order, to achieve desirable results. In certain some cases, multitasking and parallel processing may be advantageous.

## Claims

1. A method performed by one or more computers, the method comprising:
obtaining scene context data characterizing a scene in an environment at a current time point, wherein the scene includes a set of agents that comprises a plurality of target agents, and wherein the scene context data includes features of the scene in a scene-centric coordinate system;
generating a scene-centric encoded representation of the scene in the environment by processing the scene context data using an encoder neural network;
for each target agent:
obtaining agent-specific features for the target agent;
processing the agent-specific features for the target agent and the scene-centric encoded representation of the scene using a fusion neural network to generate a fused scene representation for the target agent; and
processing the fused scene representation for the target agent using a decoder neural network to generate a trajectory prediction output for the target agent that predicts a future trajectory of the target agent after the current time point in an agent-centric coordinate system for the target agent.

2. The method of claim 1, wherein the scene-centric encoded representation of the scene in the environment comprises a sequence of scene embeddings.

3. The method of claim 2, further comprising:
generating a sequence of agent embeddings from the agent-specific features using the fusion neural network.

4. The method of claim 3, wherein the fusion neural network comprises at least one cross-attention neural network block that performs cross attention between the sequence of scene embeddings and the sequence of agent embeddings.

5. The method of any preceding claim, wherein the agent-specific features for the target agent comprises agent history context data characterizing current and previous states of the target agent in the scene-centric coordinate system.

6. The method of any preceding claim, wherein the trajectory prediction output defines a probability distribution over possible future trajectories of the target agent after the current time point.

7. The method of any preceding claim, wherein:
the scene context data comprises data generated from data captured by one or more sensors of an autonomous vehicle, and
the plurality of target agents are agents in a vicinity of the autonomous vehicle in the environment.

8. The method of claim 7, further comprising:
providing (i) the trajectory prediction output for the plurality of target agents, (ii) data derived from the trajectory prediction output, or (iii) both to an on-board system of the autonomous vehicle for use in controlling the autonomous vehicle, and optionally wherein the trajectory prediction output is generated on-board the autonomous vehicle.

9. The method of any preceding claim, wherein:
the context data comprises data generated from data that simulates data that would be captured by one or more sensors of an autonomous vehicle in the real-world environment, and
the plurality of target agents are agents in a vicinity of the simulated autonomous vehicle in the computer simulation, and optionally further comprising:
providing (i) the trajectory prediction output, (ii) data derived from the trajectory prediction output, or (iii) both for use in controlling the simulated autonomous vehicle in the computer simulation.

10. The method of any preceding claim, wherein the scene context data comprises target agent history context data characterizing current and previous states of the plurality of target agents, and optionally wherein the agent-specific features are a subset of the target agent history data characterizing current and previous states of the plurality of target agents.

11. The method of any preceding claim, wherein the scene context data comprises road graph context data characterizing road features in the scene.

12. The method of any preceding claim, wherein the scene context data comprises traffic signal context data characterizing at least respective current states of one or more traffic signals in the scene.

13. The method of any preceding claim, wherein the agent-specific features for the target agent comprise a combination of features in the scene-centric coordinate system and features in the agent-centric coordinate system.

14. A system comprising:
one or more computers; and
one or more storage devices communicatively coupled to the one or more computers, wherein the one or more storage devices store instructions that, when executed by the one or more computers, cause the one or more computers to perform operations of the respective method of any one of claims 1-16.

15. Computer program instructions that when executed by one or more computers cause the one or more computers to perform the method of any one of claims 1-14.
